# EUROPEAN PATENT APPLICATION

(11) **EP 2 135 972 A1**
(43) Date of publication of application: **23.12.2009**
(21) Application number: 08711771.9
(22) Date of filing: 21.02.2008
(51) Int. Cl.: C23C 14/14, C22C 5/02, C22C 14/00, C23C 14/06, C23C 28/02

(54) **GOLD ALLOY COATING, GOLD ALLOY COATING CLAD LAMINATE AND GOLD ALLOY COATING CLAD MEMBER**

(30) Priority: 02.03.2007 JP 2007053005
(71) Applicant: Citizen Tohoku Co., Ltd., Kitakami-shi Iwate 0240002 (JP)
(72) Inventor: KARUISHI, Kenya, Kitakami-shi Iwate 024-0002 (JP)
(74) Representative: Matthews, Derek Peter
(86) International application number: PCT/JP2008/052988
(87) International publication number: WO 2008/108181

(57) **Abstract**

A reddish gold colored or pinkish gold colored gold alloy coating film having excellent functional properties and cost performance is provided by a dry plating method. The gold alloy coating film is formed by a dry plating method and comprises gold (Au) of 70 to 85 % by weight, copper (Cu) of 15 to 28 % by weight and palladium (Pd) of 0.5 to 2.0 % by weight based on 100 % by weight of the total of all the components of the gold alloy coating film. A gold alloy coating film-clad article having high functional properties including abrasion resistance and scratch resistance can be prepared by forming a hard primary plating coating film (3) on a base material (2), and forming the gold alloy coating film (4) on the upper surface of the coating film (3).

## Description

### FIELD OF THE INVENTION

The present invention relates to a gold alloy coating film, a gold alloy coating film-clad laminate having the gold alloy coating film, and a gold alloy coating film-clad article having the gold alloy coating film. Particularly, it relates to a reddish gold colored or pinkish gold colored gold alloy coating film having decorating properties, a gold alloy coating film-clad laminate having the gold alloy coating film, and a gold alloy coating film-clad article having the gold alloy coating film.

### BACKGROUND OF THE INVENTION

There are many musical instrument frames, glass frames, and accessories such as necklaces, watch exterior parts and the like which have appearances being of a pinkish gold color and are desired to have metal touch and impression. In order to satisfy these demands, techniques for preparing pinkish gold colored gold alloy substrates have been disclosed (for example, referred to Patent document 1).

It has been considered to apply pinkish gold colored gold alloy plating on another metal as a means for decreasing the amount of noble metals used, satisfying these demands more economically and enhancing functional properties such as processability, scratch resistance and the like.

As the method, a wet plating method of using a plating solution is mostly used in the market. Moreover, there is a film forming method by a dry plating method. A technique for preparing a pinkish gold colored coating film by the dry plating method has been disclosed (for example, referred to Patent document 2).

In addition, a technique concerning an alloy material containing gold as a main component by the dry plating method is disclosed for forming a pinkish gold colored coating film (for example, referred to Patent document 3). However, since the alloy material used comprises components having different evaporation conditions, it is known that the alloy components are not used, as they are, for coating film components.
Patent document 1: JP-A-H10(1998)-245646 (Tables 1 and 2)
Patent document 2: JP-A-S59(1984)-190340 (Table 1)
Patent document 3: JP-A-S61(1986)-127863 (Page 1)

### DISCLOSURE OF THE INVENTION

### SUBJECT OF THE INVENTION TO BE SOLVED

The pinkish gold colored gold alloy substrates for realizing the above objects, however, have problems such that they are expensive and also according to the blend proportion of copper (Cu) components, which are blended for giving a pinkish gold color, functional qualities such as processability and corrosion resistance are lowered.

In the case of employing plating as a means for surface coating, the coating film needs to be thick for obtaining the functional qualities of a coating film prepared by the wet plating method including corrosion resistance and scratch resistance and thereby the production cost is increased.

It is an object of the present invention to provide a pinkish gold colored gold alloy coating film formed by a dry plating method, specifically a reddish gold colored or pinkish gold colored gold alloy coating film having decorative properties, high functional qualities including corrosion resistance and scratch resistance. It is another object of the invention to provide a gold alloy coating film-clad laminate having the gold alloy coating film, and it is a further object of the invention to provide a gold alloy coating film-clad article having the gold alloy coating film.

### MEANS FOR SOLVING THE OBJECT

The gold alloy coating film of the present invention for realizing the above objects is formed by a dry plating method, and comprises gold (Au) of 70 to 85 % by weight, copper of (Cu) 15 to 28 % by weight and palladium (Pd) of 0.5 to 2.0 % by weight based on 100 % by weight of the total of all the components of the gold alloy coating film.

Moreover, the gold alloy coating film comprises, as a color tone regulating component, at least one metal of chromium (Cr), iron (Fe), cobalt (Co), nickel (Ni) and indium (In) in an amount of more than 0 % by weight and less than 1 % by weight based on 100 % by weight of the total of all the components of the gold alloy coating film.

It is preferred that the gold alloy coating film have a chromaticity such that the color evaluation, as determined by a L*a*b* color specification system (CIE color specification system) indicates 75 < L*< 100, 0 < a* < 20, and 5 < b* < 25, and it be of a reddish gold color or a pinkish gold color.

In addition, the gold alloy coating film preferably has a chromaticity such that the color evaluation, as determined by a L*a*b* color specification system (CIE color specification system) indicates 80 < L*< 90, 5 < a* < 15, and 10 < b* < 20, because it can have a practically fine pinkish gold color tone.

The gold alloy coating film, furthermore, preferably has a film thickness of 0.05 to 3.0 µm.

The gold alloy coating film-clad laminate of the present invention comprises at least one primary plating coating film and, formed on the upper surface thereof, the gold alloy coating film, and the primary plating coating film comprises at least one selected from at least one metal of a Group 4a, a Group 5a, a Group 6a, nickel (Ni) and chromium (Cr) in the Periodic Table, a carbide of the metal, a nitride of the metal, a carbon nitride of the metal and an alloy of the metals.

The gold alloy coating film-clad laminate comprises at least one primary plating coating film and, formed on the upper surface thereof, the gold alloy coating film. The primary plating coating film preferably comprises at least one selected from at least one metal of titanium (Ti), zirconium (Zr), hafnium (Hf), tantalum (Ta), vanadium (V), nickel (Ni) and chromium (Cr), a carbide of the metal, a nitride of the metal, a carbon nitride of the metal and an alloy of the metals, and the primary plating coating film is preferably hard.

The gold alloy coating film-clad laminate comprises at least one primary plating coating film and, formed on the upper surface thereof, the gold alloy coating film. The primary plating coating film preferably comprises a hard titanium alloy which comprises titanium (Ti) of 60 to 80 % by weight, carbon (C) of 2 to 15 % by weight and nitrogen (N) of 10 to 25 % by weight based on 100 % by weight of the total of all the components of the primary plating coating film.

The gold alloy coating film-clad laminate further may comprise a mixed layer formed between the gold alloy coating film and the primary plating coating film. The mixed layer comprises components forming the above the gold alloy coating film and components forming the primary plating coating film.

The gold alloy coating film-clad article of the present invention comprises a base material and, formed on the at least one part of the upper surface thereof, the gold alloy coating film.

The gold alloy coating film-clad article of the present invention comprises a base material formed on the lowermost surface of the primary plating coating film, and the above gold alloy coating film on at least one part of the uppermost surface of the primary plating coating film, and the primary plating coating film comprises at least one selected from at least one metal of a Group 4a, a Group 5a, a Group 6a, nickel (Ni) and chromium (Cr) in the Periodic Table, a carbide of the metal, a nitride of the metal, a carbon nitride of the metal and an alloy of the metals.

The gold alloy coating film-clad article, further, comprises a base material on the lower most surface of the primary plating coating film, and the gold alloy coating film on at least one part of the upper most surface of the primary plating coating film, and the primary plating coating film comprises at least one selected from at least one metal of titanium (Ti), zirconium (Zr), hafnium (Hf), tantalum (Ta), vanadium (V), nickel (Ni) and chromium (Cr), a carbide of the metal, a nitride of the metal, a carbon nitride of the metal and an alloy of the metals, and the primary plating coating film may be hard.

The gold alloy coating film-clad article, further, comprises a base material on the lower most surface of the primary plating coating film, and the gold alloy coating film on at least one part of the upper most surface of the primary plating coating film, and the primary plating coating film may be a hard titanium alloy coating film which comprises titanium (Ti) of 60 to 80 % by weight, carbon (C) of 2 to 15 % by weight and nitrogen (N) of 10 to 25 % by weight based on 100 % by weight of the total of all the components of the primary plating coating film.

The gold alloy coating film-clad article further comprises a mixed layer between the above the gold alloy coating film and the primary plating coating film, and the mixed layer preferably comprises a mixture of components forming the above the gold alloy coating film and components forming the primary plating coating film.

The gold alloy coating film-clad article may have a part where the base material appears, namely the primary plating coating film lacks.

The gold alloy coating film-clad article, further, may comprise at least one protective film on the surface of the gold alloy coating film.

With regard to the gold alloy coating film-clad article, the base material may comprise at least one metal selected from platinum (Pt), gold (Au), silver (Ag), copper (Cu), titanium (Ti), aluminum (Al), tungsten (W), tantalum (Ta), zirconium (Zr), silicon (Si), stainless steel and brass, or an alloy of these metals.

With regard to the gold alloy coating film-clad article, the base material may comprise sintered ceramic, glass or plastic.

With regard to the gold alloy coating film-clad article, the base material may be a metal subjected to hardening treatment. The hardening treatment may be any one of a) at least one chemical reaction of nitriding, carbonization and oxidation, b) doping with at least one element of nitrogen, carbon and oxygen, and c) solid solution with at least one element of nitrogen, carbon and oxygen.

With regard to the gold alloy coating film-clad article, the base material is desirably an ornament.

With regard to the gold alloy coating film-clad article, the base material, furthermore, is desirably an exterior part of a watch.

Since the content of noble metals used is large in reddish gold colored or pinkish gold colored gold alloy base materials or gold alloy coating films prepared a wet plating method in conventional techniques, the production coat thereof is high and they have difficult points in functional properties such as corrosion resistance and scratch resistance. Under the circumstances, the present inventors have been earnestly studied in order to obtain a coating film having a specific component ratio, having a very thin thickness, excellent scratch resistance, and no problems in corrosion resistance. As a result, they found composition conditions of a gold alloy coating film having excellent market value, being of a pinkish gold color, and also having excellent corrosion resistance and cost performance.

Moreover, they found that even if the gold alloy coating film of the present invention is partly scratched by a local stress, scratches in appearance are not distinguished by the color tone and the hardness of a primary plating coating film which is prepared by earnest examinations, and in consequence, the quality in appearance and scratch resistance as an ornament can be maintained.

### EFFECT OF THE INVENTION

As described above, since the gold alloy coating film according to the present invention comprises gold (Au) as a main component, and further copper (Cu) of 15 to 30 % by weight and palladium (Pd) of 0.5 to 2.0 % by weight based on 100 % by weight of the total of all the components of the gold alloy coating film, the gold alloy coating film having excellent market value and being of a reddish gold color or pinkish gold color, and also having high corrosion resistance can be prepared.

Furthermore, according to the present invention, by forming a primary plating coating film on the base material surface, and forming the gold alloy coating film on the upper surface of the primary plating coating film, a coating film having excellent scratch resistance and high functional properties even if having a thin thickness can be prepared in a low production cost, and further, by providing a base material exposed part on one part of the primary plating coating film, the design properties and color variation can be further improved, and also high-grade feeling gold color hard coating film-clad laminates and gold alloy coating film-clad articles can be prepared. Moreover, by providing a transparent protective film, not only a gold alloy coating film-clad article being of a more vivid color can be prepared but also peeling or wear of the gold alloy coating film can be prevented and also scratches caused by outer contact can be prevented.

### BRIEF DESCRIPTION OF DRAWING

Fig. 1 is a view of an eyeglass frame as a gold alloy coating film-clad article in Example 1, Fig. 1(a) is a perspective view and Fig. 1(b) is a partly enlarged sectional view in Fig. 1(a).
Fig. 2 is a view of a watch hand as a gold alloy coating film-clad article in Example 2, Fig. 2(a) is a perspective view and Fig. 2(b) is a sectional view taken substantially along the lines A-A in Fig. 2(a).
Fig. 3 is a view of a watchband as a gold alloy coating film-clad article in Example 3, Fig. 3(a) is a perspective view and Fig. 3(b) is a partly enlarged sectional view in Fig. 3(a).
Fig. 4 is a view of a ring as a gold alloy coating film-clad article in Example 4, Fig. 4(a) is a perspective view and Fig. 4(b) is a sectional view taken substantially along the lines B-B in Fig. 4(a).
Fig. 5 is a view of a watchcase as a gold alloy coating film-clad article in Example 5, Fig. 5(a) is a perspective view and Fig. 5(b) is a sectional view taken substantially along the lines C-C in Fig. 5(a).
Fig. 6 is a view of a watchband as a gold alloy coating film-clad article in Example 6, Fig. 6(a) is a perspective view and Fig. 6(b) is a partly enlarged sectional view in Fig. 6(a).

### REFERENCE NUMERAL

1 ... Eyeglass frame
2 ... Base material of eyeglass frame
3 ... Gold alloy coating film
4 ... Transparent protective film
5 ... Watch hand
6 ... Base material of watch hand
7 ... Primary plating coating film
8 ... Gold alloy coating film
9 ... Watchband
10... Base material of watchband
11... Primary plating coating film
12... Gold alloy coating film
13... Mixed layer
14... Ring
15... Base material of ring
16... Gold alloy coating film
17... Watchcase
18... Base material of watchcase
19... Primary plating coating film
20... Gold alloy coating film
21... Watchband
22... Base material of watchband
23... Surface hardened layer
24... Primary plating coating film
25... Primary plating coating film
26... Primary plating coating film
27... Gold alloy coating film
28... Mixed layer

### BEST MODE FOR CARRYING OUT THE INVENTION

The gold alloy coating film in the embodiment of the present invention is a gold alloy coating film formed by a dry plating method. The gold alloy coating film comprises gold (Au) of 72 to 85 % by weight, copper (Cu) of 15 to 28 % by weight and palladium (Pd) of 0.5 to 2.0 % by weight based on 100 % by weight of the total of all the components in the gold alloy coating film. Furthermore, the gold alloy coating film of the present embodiment may comprise, as a color tone regulating component, at least one metal of chromium (Cr), iron (Fe), cobalt (Co), nickel (Ni) and indium (In) in an amount of more than 0 % by weight and less than 1 % by weight based on 100 % by weight of the total of all the components in the gold alloy coating film. In containing these metals, the color tone of the gold alloy coating film can be finely regulated in accordance with the demand.

The percent by weight of each metal in the gold alloy coating film is determined using an energy dispersion type X-ray analyzing device (EDX) manufactured by Horiba Ltd by a standard-less method.

The gold alloy coating film is formed to have a thickness of preferably 0.05 to 3.0 µm. The thickness is undesirably less than 0.05 µm because the color of the primary layer is shown through the gold alloy coating film and thereby the color of the gold alloy coating film itself cannot come out well. Meanwhile, the thickness is also undesirably more than 3. 0 µm, because the surface roughness in the method of forming the coating film is increased to cause dark color, and since the coating film stress is increased, the coating film easily peels and the production cost of the coating film is higher than that of the wet plating method.

The measurement of the thickness of the gold alloy coating film was carried out using a fluorescent X-ray thickness meter manufactured by Seiko Instrument Ltd.

The gold alloy coating film of the present embodiment is of a reddish gold or pinkish gold color, and preferably has a chromaticity of 75<L*<100, 0<a*<20 and 5<b*<25, as determined by color evaluation with L*a*b* color specification (CIE color specification). Specifically, it more preferably has a chromaticity of 80<L*<90, 5<a*<15 and 10<b*<20. The chromaticity in this range satisfies the range of pinkish gold color. When the chromaticity departs from this range, the color of reddish gold or pinkish gold does not practically come out well and therefore the trade value is lowered.

The color evaluation with L*a*b* color specification (CIE color specification) shows the following feeling chromaticity by a color coordinate used in International Commission on Illumination. The color evaluation with L*a*b* color specification was carried out using a spectrophotometer manufactured by Konica Minolta Holdings, Inc. in accordance with JIS Z8722 by a diffused lighting receiving method.

L*: Black ← minus (-) side, plus (+) side → White
a*: Green ← minus (-) side, plus (+) side → Red
b*: Blue ← minus (-) side, plus (+) side → Yellow
Moreover, on the base material surface, a primary plating coating film is formed, and on one part of the primary plating coating film, a primary plating coating film exposed part where the gold alloy coating film lacks may be formed. This primary plating coating film can be formed by any one of a wet plating and a dry plating, and in using the primary plating coating film having a color different from that of the gold alloy coating film, it is possible to make two-tone color by combining the primary plating coating film exposed part and the gold alloy coating film. As a result, the design properties and color variation can be further improved, and also it is possible to prepare reddish gold colored or pinkish gold colored coating film-clad laminates and articles having fashionable appearance. Moreover, on one part of the primary plating coating film exposed part, a base material-exposed part where the primary plating coating film lacks can be formed and therefore, many colors can be combined and multi-color can be realized.

The primary plating coating film may have a multi layer structure of 2 to 6 layers. In this case, the coating film-clad laminate or article can have high functional properties such as scratch resistance, abrasion resistance and the like, and further, in using multi colors, it is possible to prepare products having very high design properties. The primary plating coating film having a multi-layer structure comprises at least one selected from at least one metal of Group 4a, Group 5a, Group 6a, nickel (Ni) and chromium (Cr) in the Periodic Table, a carbide of the metal, a nitride of the metal, a carbon nitride of the metal and an alloy of the metals, and may have a multi-layer structure of the same metal or the combined metals.

When the primary plating coating film comprises at least one selected from at least one metal of titanium (Ti), zirconium (Zr), hafnium (Hf), tantalum (Ta), vanadium (V), nickel (Ni) and chromium (Cr), a carbide of the metal, a nitride of the metal, a carbon nitride of the metal and an alloy of the metals, the resulting primary plating coating film is harder as compared with a general economical primary plating coating film formed by nickel plating in a wet plating method or the base material itself.

Particularly, the primary plating coating film preferably comprises titanium (Ti) of 60 to 80 % by weight, carbon (C) of 2 to 15 % by weight and nitrogen (N) of 10 to 25 % by weight based on 100 % by weight of the total of all the components of the primary plating coating film, because the resulting hard titanium alloy has more improved abrasion resistance and scratch resistance. Moreover, since the carbon nitride titanium (TiCN) coating film has a color tone near the gold alloy coating film, even if local damages are caused in the gold alloy coating film, they are not discerned.

On the surface of the gold alloy coating film-clad article, that is to say, on the base material exposed part, the primary plating coating film exposed part or at least one part of the gold alloy coating film, a transparent protective film can be provided. The protective film can prevent the gold alloy coating film or the primary plating coating film from peeling or wear and tear, or scratches caused by the contact with the outside. Furthermore, it is possible to prepare a gold alloy coating film-clad article being of a more vivid gold color by setting of the transparent protective film on the surface.

The base material of the present embodiment comprises various metals such as platinum (Pt), gold (Au), silver (Ag), copper (Cu), titanium (Ti), aluminum (Al), tungsten (W), tantalum (Ta), zirconium (Zr), silicon (Si), stainless and brass, and alloys of these metals. Moreover, it is possible to use sintered ceramic, glass, plastic and other various materials. Accordingly, the gold alloy coating film-clad articles in the present embodiment can be used for many products such as dishes, toys, statues and the like, particularly, they exhibit excellent effects for ornaments and watch exterior parts.

### EXAMPLE

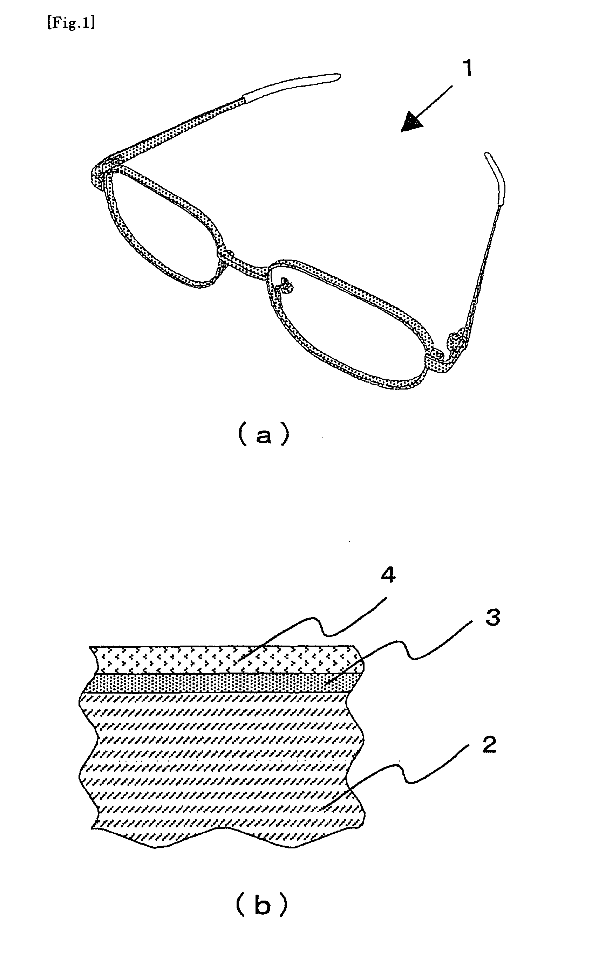

Figures 1 to 6 show gold alloy coating film-clad articles in Examples 1 to 6. The embodiments of the gold alloy coating film, gold alloy coating film-clad laminate and gold alloy coating film-clad article according to the present invention will be described with reference to Figures 1 to 6 below.

### Example 1

In Example 1, a gold alloy coating film-clad article is an eyeglass frame. A pinkish gold colored gold alloy coating film is provided on the overall surface of the eyeglass frame and then a transparent protective film is provided on the overall surface of the eyeglass frame.

Fig. 1 is a view of an eyeglass frame as a gold alloy coating film-clad article in Example 1, Fig. 1(a) is a perspective view and Fig. 1(b) is a partly enlarged sectional view in Fig. 1(a).

As shown in Fig. 1, in the eyeglass frame 1 as a gold alloy coating film-clad article in Example 1, a base material 2 comprises a titanium (Ti) material, and a gold alloy coating film 3 having a thickness of 0.3 µm is formed on the overall surface of the base material 2.

The gold alloy coating film 3 comprises gold (Au) of 75.4 % by weight, copper (Cu) of 23.5 % by weight and palladium (Pd) of 1.1 % by weight, and has a chromaticity such that the color evaluation, as determined by L*a*b* color specification system (CIE specification system), indicates L*= 85, a*=10, and b*=15 and is of a vivid pinkish gold color.

The gold alloy coating film 3 is formed by a sputtering method in a dry plating method, and the coating film forming method thereof will be described below.

In a chamber of a vacuum device, a gold alloy (alloy of Au, Cu and Pd) target and, as a subject to be treated, a base material 2 of an eyeglass frame 1 were fixed on a holder and disposed at a distance of about 80 mm between the gold alloy target and the base material, and the chamber was evacuated to be 5.0 x 10⁻³Pa. Thereafter, an argon gas was introduced at a flow rate of 150 cc/min into the vacuum chamber and thereby the degree of vacuum was regulated to be 0.2 Pa.

Thereafter, the gold alloy target was subjected to sputtering for about 30 min.

After cooling for about 20 min, the chamber pressure was returned to atmospheric pressure, and then the base material 2 of the eyeglass frame 1 as a subject to be treated was taken out. It was confirmed that a uniform pinkish gold colored gold alloy coating film 3 was formed on the base material 2 of the eyeglass frame 1.

It is further confirmed that the gold alloy coating film 3 was thinner as compared with one prepared by a wet-plating method in conventional techniques, and had a uniform color tone.

According to the present example, it is possible to prepare the eyeglass frame having excellent decorative properties and being of a pinkish gold color.

The vacuum device used in the example is equipped with a mechanism for rotating the holder such that the subject to be treated is rotated with the rotation of the holder.

The composition of the gold alloy target has been previously regulated to the composition of the gold alloy coating film 3 by the treating conditions of the example.

Next, a mixture of a first agent and a second agent of a two-liquid type urethane coating was applied on the overall surface of the gold alloy coating film 3 formed on the overall surface of the base material 2 of the eyeglass frame by a spray etc.

Thereafter, it was kept with heat at 70°C for 60 min and thereby cured, to prepare a transparent protective film 4.

As described above, on the overall surface of a base material having a complex shape such as eyeglass frame, a uniform and vivid pinkish gold colored gold alloy coating film can be formed according to the present invention.

Since the gold alloy coating film 3 formed on the surface of the eyeglass frame 1 is greatly thinner as compared with one formed by a wet plating method, and the content of noble metals is depressed, the coating film has excellent cost performance.

Moreover, since the transparent protective film 4 is formed on the overall surface of the gold alloy coating film 3 formed on the surface of the eyeglass frame 1, peeling or wear of the gold alloy coating film 3 is prevented, and further scratches caused by the contact with the outside can be prevented.

In addition, a more vivid pinkish gold colored eyeglass frame can be prepared by the function of the transparent protective film 4.

### Example 2

The gold alloy coating film-clad article in Example 2 is an example of a watch hand for watches. On the overall surface of the watch hand, a primary plating coating film is formed by a wet plating method and a gold alloy coating film is formed on one part of the primary plating coating film.

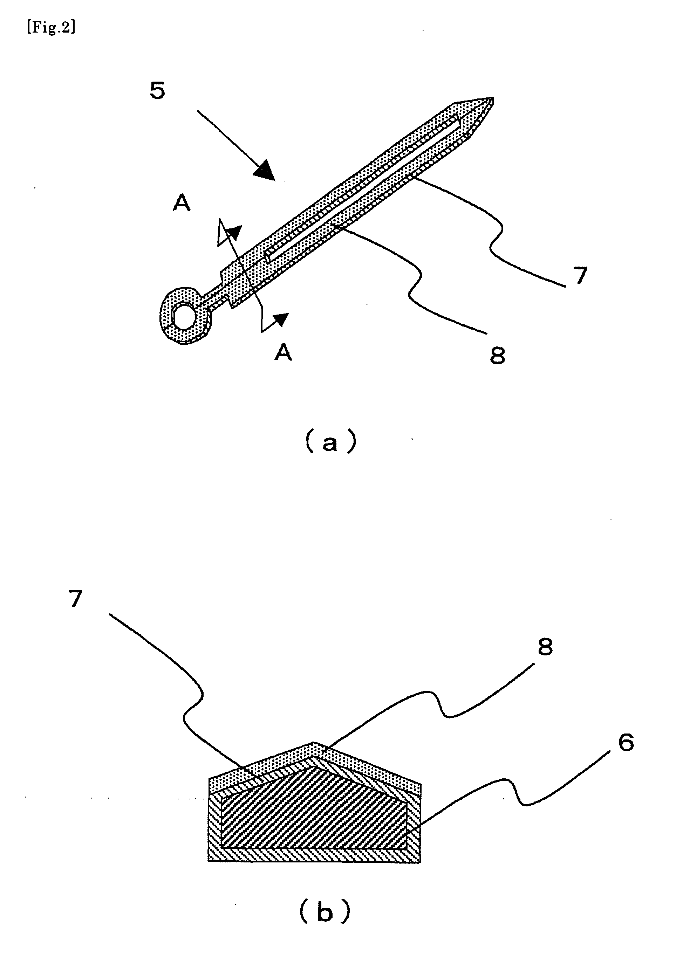

Fig. 2 is a view of a watch hand 5 as the gold alloy coating film-clad article in Example 2, Fig. 2(a) is a perspective view and Fig. 2(b) is a sectional view of the watch hand 5 taken substantially along the lines A-A in Fig. 2(a).

As shown in Fig. 2, in the watch hand 5 for watches as the gold alloy coating film-clad article in Example 2, the base material 6 comprises a brass material and nickel (Ni) plating was applied as a primary plating coating film 7 by the wet plating method.

The nickel-plating coating film as the primary plating coating film 7 has a thickness of 2.0 µm. Furthermore, a gold alloy coating film 8 having a thickness of 0.5 µm is formed on the upper surface part of the primary plating coating film 7 corresponding to the upper surface side of the watch hand 5.

The gold alloy coating film 8 comprises gold (Au) of 78.5 % by weight, copper (Cu) of 20.6 % by weight and palladium (Pd) of 0.9 % by weight, and has a chromaticity such that the color evaluation, as determined by L*a*b* color specification (CIE color specification system), indicates L*= 82, a*=12 and b*=14 and is of a vivid pinkish gold color.

The gold alloy coating film 8 is formed by an ion plating method in a dry plating method, and the coating film forming method thereof will be described below.

In a chamber of a vacuum device, a gold alloy (alloy of Au, Cu and Pd) was set as an evaporation material in a crucible, and a base material 6 of the watch hand 5 that nickel (Ni) plating was applied by a wet plating method as the primary plating coating film 7 on the overall surface was installed on a plate-like sticking type holder as a subject to be treated, and was disposed at a distance of about 200 mm to the crucible in which the gold alloy was put as an evaporation material. Thereafter, the chamber was evacuated to be 5.0 x 10⁻³Pa, and then an argon gas was introduced at a flow rate of 150 cc/min into the vacuum chamber and thereby the degree of vacuum was regulated to be 0.2 Pa.

Thereafter, 30 V of a cathode voltage was applied on the subject to be treated, and then the gold alloy set in the crucible as an evaporation material was evaporated with irradiation of electron beam, and ion plating was carried out for about 20 min.

After cooling for about 20 min, the chamber pressure was returned to atmospheric pressure, and then the base material 6 of the watch hand 5 as a subject to be treated was taken out. It was confirmed that a uniform pinkish gold colored gold alloy coating film 8 was formed on the upper surface of the base material 6 of the watch hand 5.

It is further confirmed that the gold alloy coating film 8 was thinner as compared with one prepared by a wet plating method in conventional techniques, and had a uniform color tone.

According to the present example, it is possible to prepare the watch hand having excellent decorative properties and being of a vivid pinkish gold color.

The vacuum device used in the example is equipped with a mechanism for rotating the holder such that the subject to be treated is rotated with the rotation of the holder. On the back surface of the watch hand 5, which was contact with the holder, the pinkish gold colored gold ally coating film 8 was not formed because the back surface was put on the holder.

The composition of the gold alloy as an evaporation material has been previously regulated to the composition of the gold alloy coating film 8 according to the treating conditions of the example.

As described above, on only the necessary part, which is watched by eyes, such as watch hands, a vivid pinkish gold colored gold alloy coating film can be formed according to the present example.

As a result, the watch hand having excellent decorative properties and being of a vivid pinkish gold color can be prepared and further the design properties and color variation of the watch hand can be further improved.

Since the nickel plating coating film was formed on the surface of the watch hand as the primary plating coating film, the watch hand having excellent corrosion resistance and being of a vivid pinkish gold color can be prepared as compared with one prepared by only a brass material.

### Example 3

The gold alloy coating film-clad article in Example 3 is an example of a watchband. On the overall surface thereof, a primary plating coating film is formed by a dry plating method and on the upper surface of the primary plating coating film, a gold alloy coating film was formed.

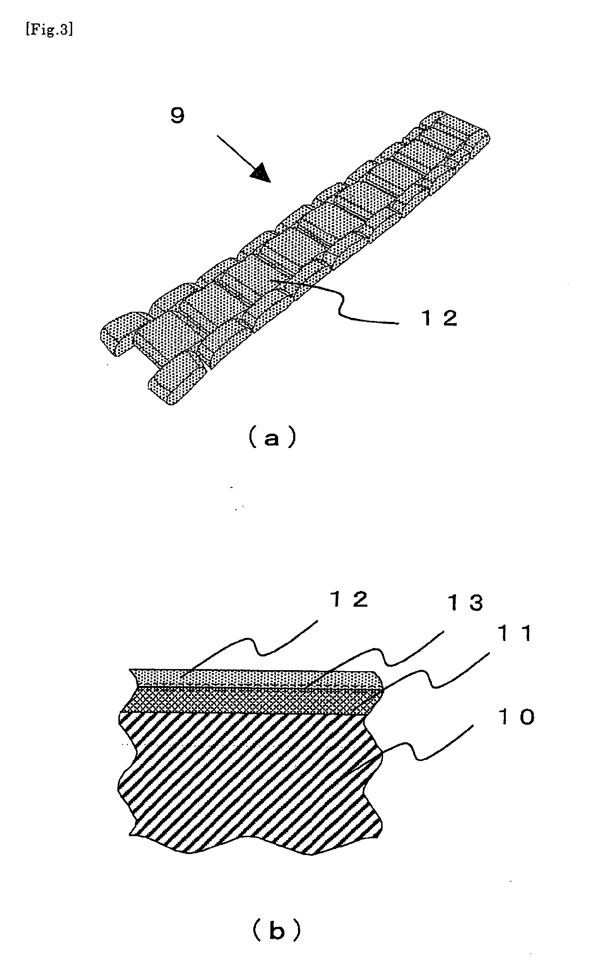

Fig. 3 is a view of a watchband 9 as a gold alloy coating film-clad article in Example 3, Fig. 3(a) is a perspective view and Fig. 3(b) is a partly enlarged sectional view in Fig. 3(a).

As shown in Fig. 3, in the gold alloy coating film-clad article of the present example, a base material 10 of the watchband 9 is made of a stainless steel material, and a coating film of titanium carbon nitride (TiCN, titanium alloy containing titanium of 78 % by weight, carbon of 5 % by weight and nitrogen of 13 % by weight) is formed as the primary plating coating film 11 by a dry plating method. The percent by weight of titanium, carbon or nitrogen in the titanium carbon nitride is determined by using an energy dispersion type X-ray analyzing device (EDX) manufactured by Horiba Ltd by a standard-less method (hereinafter, the percent by weight was determined by the same procedure).

The titanium carbon nitride (TiCN) coating film as the primary plating coating film 11 has a thickness of 0.6 µm.

Furthermore, on the upper surface of the primary plating coating film 11 formed on the overall surface of the watchband 9, a gold alloy coating film 12 having a thickness of 0.2 µm is formed, and between the primary plating coating film 11 and the gold alloy coating film 12, a mixed layer 13 of the components of the both layers is provided.

The gold alloy coating film 12 comprises gold (Au) of 76.4 % by weight, copper (Cu) of 22.7 % by weight and palladium (Pd) of 0.9 by weight, has a chromaticity such that the color evaluation, as determined by L*a*b* color specification (CIE specification system), indicates L*= 86, a*=11 and b*=15, and is of a vivid pinkish gold color.

The primary plating coating film 11 and the gold alloy coating film 12 were formed by an ion plating method in the dry plating method, and the coating film forming method thereof will be described below.

In a chamber of a vacuum device, titanium (Ti) and a gold alloy (alloy of Au, Cu and Pd) were separately set as an evaporation material in crucibles, and the base material 10 of the watch band 9 was set on a holder as a subject to be treated, and was disposed at a distance of about 200 mm to the crucibles in which the evaporation materials were set. The chamber was evacuated to be 5.0 x 10⁻³Pa, and then an argon gas, a nitrogen gas and a methane gas were introduced at a flow rate of 100 cc/min, 150 cc/min and 50 cc/min respectively into the vacuum chamber and thereby the degree of vacuum was regulated to be 0.1 Pa.

Thereafter, 30 V of a cathode voltage was applied on the subject to be treated, and then the titanium set in the crucible as an evaporation material was evaporated with irradiation of electron beam, and ion plating was carried out for about 40 min.

Thereafter, the introduction of a nitrogen gas and a methane gas was stopped, and an argon gas was introduced into the vacuum chamber at a flow rate of 80 cc/min and thereby the degree of vacuum was regulated to be 0.25 Pa.

Thereafter, 10 V of a cathode voltage was applied on the subject to be treated, and then the gold alloy set in the crucible as an evaporation material was evaporated with irradiation of electron beam, and ion plating was carried out for about 20 min.

Electron beam irradiation on the gold alloy as an evaporation material was started while electron beam irradiation on the titanium as an evaporation material was stopped gradually, and thereby the mixed layer 13 containing the components both of the evaporation materials was formed.

After cooling for about 20 min, the chamber pressure was returned to atmospheric pressure, and then the base material 10 of the watchband 9 as a subject to be treated was taken out. It was confirmed that a uniform pinkish gold colored gold alloy coating film 12 was formed on the upper surface of the base material 10 of the watchband 9.

It was also confirmed that the gold alloy coating film 12 was thinner as compared with one formed by a wet plating method in conventional techniques, and had a uniform color tone.

According to the present example, it is possible to prepare the watchband having excellent decorative properties and being of a vivid pinkish gold color.

The vacuum device used in the example is equipped with a mechanism for rotating the holder such that the subject to be treated is rotated with the rotation of the holder.

The composition of the gold alloy as an evaporation material has been previously regulated to the composition of the gold alloy coating film 12 by the treating conditions of the example.

As described above, on the overall surface of the watchband 9, the uniform vivid pinkish gold colored gold alloy coating film 12 can be formed according to the present example.

Moreover, the gold alloy coating film 12 formed on the overall surface of the watchband 9 is improved in functional qualities such as abrasion resistance, scratch resistance, etc by providing a hard primary plating coating film 11. Therefore, when the coating film is flawed partly, the flaws are not discerned by the titanium carbon nitride (TiCN) coating film which is the colored primary plating coating film having the color tone similar to one of the gold alloy coating film 12.

Since the mixed layer 13 is provided between the gold alloy coating film 12 and the primary plating coating film 11, the adhesion between the gold alloy coating film 12 and the primary plating coating film 11 is high and thereby there is no occurrence of problems such as delamination or the like.

### Example 4

The gold alloy coating film-clad article in Example 4 is an example of a ring that a gold alloy coating film is formed on one part of the surface of the ring by a dry plating method.

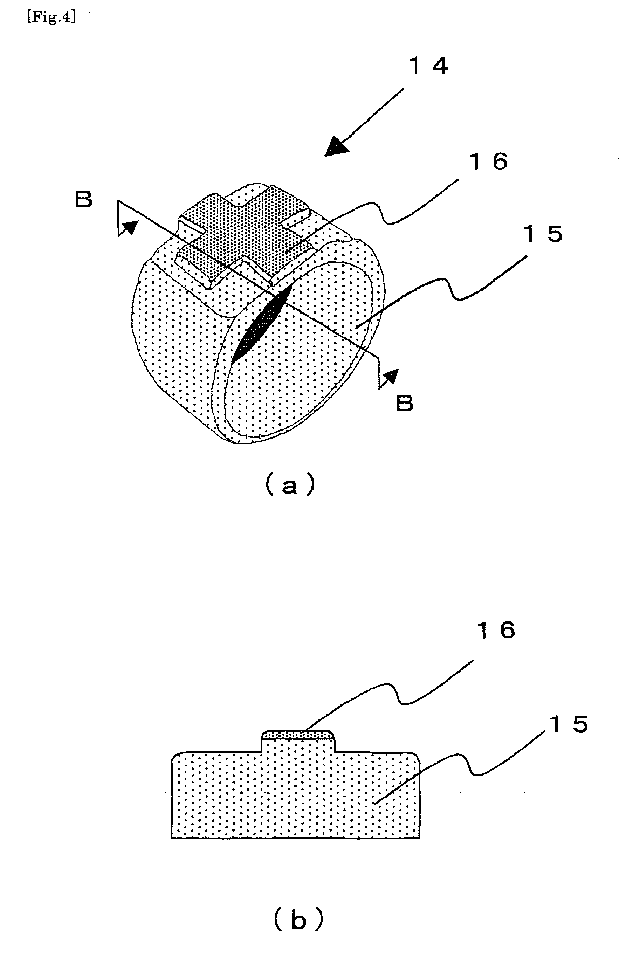

Fig 4 is a view of a ring 14 as a gold alloy coating film-clad article in Example 4, Fig. 4(a) is a perspective view and Fig. 4 (b) is a sectional view of the ring 14 taken substantially along the lines B-B in Fig. 4(a).

As shown in Fig. 4, a base material 15 of the ring 14 used as the gold alloy coating film-clad article in the present invention is made from a platinum (Pt) material and a gold alloy coating film 16 having a thickness of 0.3 µm is formed on one part of the surface of the base material 15 by a dry plating method.

The gold alloy coating film 16 comprises gold (Au) of 78.4 % by weight, copper (Cu) of 20.1 % by weight, palladium (Pd) of 1.0 % by weight and cobalt (Co) of 0.5 % by weight, and has a chromaticity such that the color evaluation, as determined by L*a*b* color specification (CIE specification system), indicates L*=86, a*=9 and b*=15 and is of a clear pinkish gold color.

The gold alloy coating film 16 is formed by an ion plating method in a dry plating method, and the coating film forming method thereof will be described below.

In a chamber of a vacuum device, a gold alloy (alloy of Au, Cu, Pd and Co) was set as an evaporation material in a crucible, and the base material 15 of the ring 14 was set on a holder as a subject to be treated, and was disposed at a distance of about 100 mm to the crucible in which the gold alloy as the evaporation materials was set. Thereafter, the chamber was evacuated to be 5.0 x 10⁻³ Pa, and then an argon gas was introduced at a flow rate of 150 cc/min into the vacuum chamber and thereby the degree of vacuum was regulated to be 0.2 Pa.

Thereafter, 10 V of a cathode voltage was applied on the subject to be treated, and then the gold alloy set in the crucible as an evaporation material was evaporated with irradiation of electron beam, and ion plating was carried out for about 30 min.

After cooling for about 20 min, the chamber pressure was returned to atmospheric pressure, and then the base material 15 of the ring 14 as a subject to be treated was taken out. It was confirmed that the uniform pinkish gold colored gold alloy coating film 16 was formed on the upper surface of the base material 15 of the ring 14.

It was also confirmed that the gold alloy coating film 16 was thinner as compared with one formed by a wet plating method in conventional techniques, and had a uniform color tone.

On the part which is one part of the surface of the ring 14 taken out from the chamber and needs forming of the gold alloy coating film 16 for finished design, a thinner solvent type masking material was applied and drying of the masking material was carried out at 100° C for 60 min.

Thereafter, the ring 14 was immersed in a gold removing solution and thereby the gold alloy coating film 16 was removed, and then the masking material was removed by an organic solvent.

According to the removal, on the part protected by the masking material, the gold alloy coating film 16 was remained, and on the part that was not protected by the masking material, a base material 15-exposed part where the gold alloy coating film 16 was not formed was formed.

According to the present example, it is possible to prepare the ring having excellent decorative properties and being of a pinkish gold color.

The vacuum device used in the example is equipped with a mechanism for rotating the holder such that the subject to be treated, which is adhered to the holder, is rotated with the rotation of the holder.

The composition of the gold alloy as an evaporation material has been previously regulated to the composition of the gold alloy coating film 16 by the treating conditions of the example.

As described above, on one part of the surface of the ring 14, the uniform and clearly pinkish gold colored gold alloy coating film 16 can be formed according to the present invention.

As a result, the ring having excellent decorative properties and being of a pinkish gold color can be formed. Moreover, by the treatment, it is possible to prepare a two-tone design such that the pinkish gold colored gold alloy coating film 16 was formed on one part of the surface.

### Example 5

The gold alloy coating film-clad article in Example 5 is an example of a watch case that on the part of the surface thereof, a primary plating coating film is formed by a dry plating method, and on the upper surface of the primary plating coating film, a gold alloy coating film is formed.

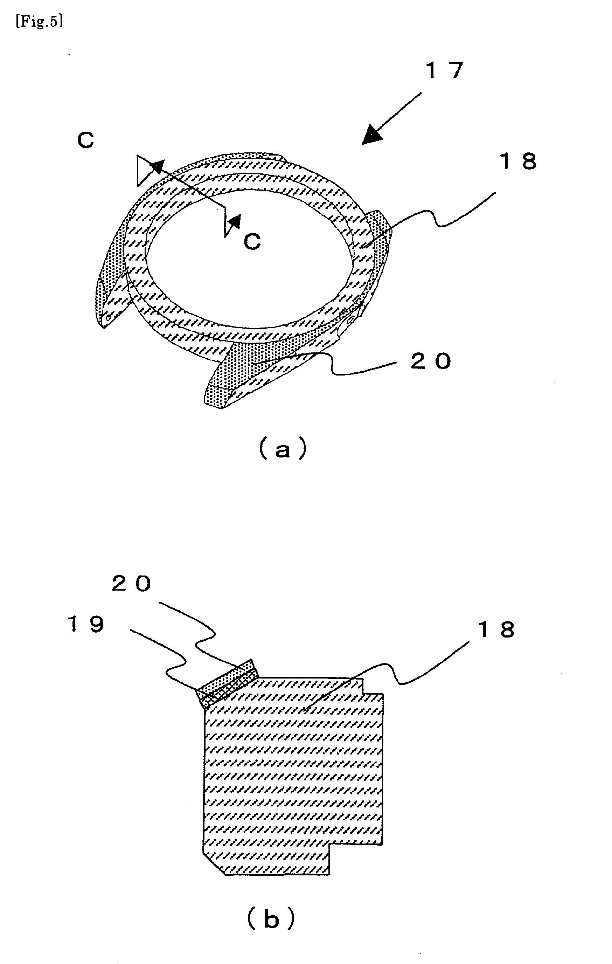

Fig 5 is a view of a watchcase 17 as a gold alloy coating film-clad article in Example 5, Fig. 5(a) is a perspective view and Fig. 5(b) is a sectional view of the watchcase 17 taken substantially along the lines C-C in Fig. 5(a).

As shown in Fig.5, a base material 18 of the watch case 17 as the gold alloy coating film-clad article in the present invention is made from a titanium (Ti) material and a titanium carbon nitride (TiCN, titanium alloy containing titanium of 82 % by weight, carbon of 6% by weight and nitrogen of 12 % by weight) coating film is formed as a primary plating coating film 19 on one part of the surface by a dry plating method.

The titanium carbon nitride (TiCN) coating film formed as the primary plating coating film 19 has a thickness of 0.6 µm.

On the upper surface of the primary plating coating film 19, which has been formed on one part of the surface of the watchcase 17, a gold alloy coating film 20 having a thickness of 0.2 µm is formed.

The gold alloy coating film 20 comprises gold (Au) of 77.4 % by weight, copper (Cu) of 20.8 % by weight, palladium (Pd) of 1.2 % by weight and nickel (Ni) of 0.6% by weight, and has a chromaticity such that the color evaluation, as determined by L*a*b* color specification (CIE specification), indicates L*=83, a*=10 and b*=16 and is of a more red pink gold color.

The primary plating coating film 19 and the gold alloy coating film 20 were formed by a sputtering method in the dry plating method, and the coating film forming method thereof will be described below.

On one part of the surface of the watchcase 17 where the gold alloy coating film 20 is unnecessary for finished design, an epoxy type masking material was applied and baking of the masking material was carried out by an oven at 200°C for 60 min.

The watchcase 17 to which the masking material was applied was taken out from the oven and cleaning treatment with water washing for the watchcase was carried out as a pretreatment. Thereafter, in a chamber of a vacuum device, a titanium (Ti) target, a gold alloy (alloy of Au, Cu, Pd and Ni) target, and the base material 18 of the watch case 17 as a subject to be treated were installed on a holder and disposed at a distance of about 100 mm between the gold alloy target and the base material. Thereafter, the chamber was evacuated to be 5.0 x 10⁻³ Pa.

Afterward, an argon gas, a nitrogen gas and a methane gas were introduced into the vacuum chamber at a flow rate of 150 cc/min, 100 cc/min and 50 cc/min respectively and thereby the degree of vacuum was regulated to be 0.2 Pa.

After the titanium target was subjected to sputtering for about 40 min, the introductions of a nitrogen gas and a methane gas were stopped and an argon gas was introduced into the vacuum chamber at a flow rate of 120 cc/min and thereby the degree of vacuum was regulated to be 0.2 Pa.

Thereafter, the gold alloy target was subjected to sputtering for about 20 min.

After cooling for about 20 min, the chamber pressure was returned to the atmospheric pressure, and then the base material 18 of the watchcase 17 was taken out as a subject for treatment. It was confirmed that a uniform pinkish gold colored gold alloy coating film 20 was formed on the base material 18 of the watchcase 17.

Since the epoxy masking material was applied on one part surface of the watchcase 17 taken from the chamber, the masking material was removed by acid treatment.

By the acid treatment, the primary plating coating film 19 and the gold alloy coating film 20 formed on the upper surface of the masking material were removed together. Therefore, on the part where the masking material was applied, a base material 18-exposed part where the primary plating coating film 19 and the gold alloy coating film 20 were not formed was formed.

Moreover, it was confirmed that the gold alloy coating film 20, which was thinner as compared with one prepared by a wet plating method in conventional techniques and had a uniform color tone, was formed.

According to the present example, it is possible to prepare the watchcase having, in the part thereof, the gold alloy coating film, which has excellent decorative properties and is of a more red pink gold color.

The vacuum device used in the example is equipped with a mechanism for rotating the holder such that the subject to be treated is rotated with the rotation of the holder.

The composition of the gold alloy target has been previously regulated to the composition of the gold alloy coating film 20 by the treating conditions of the example.

According to the present invention, as described above, the uniform more red pink gold colored gold alloy coating film 20 can be formed, on one part of the surface of the watchcase 17.

Furthermore, the gold alloy coating film 20 formed on the part of the surface of the watchcase 17 is improved in functional qualities such as abrasion resistance, scratch resistance, etc by providing the hard primary plating coating film 19. Therefore, even if the watchcase is flawed partly, the flaws are not discerned by the titanium carbon nitride (TiCN), which is the colored primary plating coating film 19 having the color tone similar to the gold alloy coating film 20.

Moreover, by the treatment, it is possible to prepare a two-tone design that the pinkish gold colored gold alloy coating film 20 was formed on one part of the surface.

### Example 6

The gold alloy coating film-clad article in Example 6 is an example of a watchband that hardening treatment is applied on a base material by nitrogen solid solution, a hard primary plating coating film is formed on the overall surface of the base material by a dry plating method, and a gold alloy coating film having a hard primary plating coating film is formed on one part of the upper surface of the primary plating coating film.

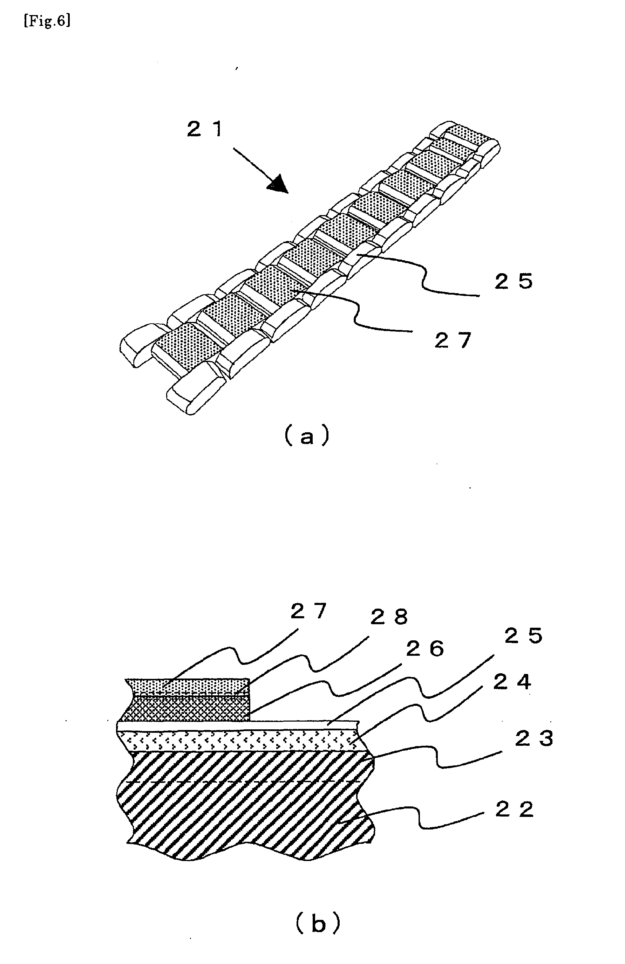

Fig. 6 is a view of a watchband 21 as a gold alloy coating film-clad article in Example 6, Fig. 6(a) is a perspective view and Fig. 6(b) is a partly enlarged sectional view in Fig. 6(a).

As shown in Fig. 6, a base material 22 of the watchband 21 used as the gold alloy coating film-clad article in the present example is made from a titanium (Ti) material, and a surface hardened layer 23 was applied thereon by a nitrogen solid solution treatment.

A titanium carbide (TiC) coating film is formed as a primary plating coating film 24 on the overall surface by the dry plating method, and further a platinum (Pt) coating film is formed as the primary plating coating film 25 on the overall upper surface of the titanium carbide (TiC) coating film by a dry plating method.

On one part of the upper surface of the platinum (Pt) coating film formed on the overall surface, a titanium carbon nitride (TiCN) coating film as the primary plating coating film 26 and a gold alloy coating film 27 are formed by a dry plating method. Furthermore, there is provided a gold alloy coating film-clad laminate that between the primary plating coating film 26 and the gold alloy coating film 27, a mixed layer 28 which comprises components both of the primary plating coating film 26 and the gold alloy coating film 27 is present.

The titanium carbide (TiC) coating film as the primary plating coating film 24 has a thickness of 0.6 µm, the platinum (Pt) coating film as the primary plating coating film 25 has a thickness of 0.1 µm, the titanium carbon nitride (TiCN) coating film as the primary plating coating film 26 has a thickness of 0.3 µm, and the gold alloy coating film 27 has a thickness of 0.1 µm.

The gold alloy coating film 27 comprises gold (Au) of 78.0 % by weight, copper (Cu) of 21.1 % by weight and palladium (Pd) of 0.9 % by weight, and has a chromaticity such that the color evaluation, as determined by L*a*b* color specification system (CIE specification system), indicates L*=86, a*=12 and b*=15 and is of a vivid pinkish gold color.

The primary plating coating film 24, the primary plating coating film 25, the primary plating coating film 26, the mixed layer 28 and the gold alloy coating film 27 were formed by an ion plating method in the dry plating method, and the coating film or layer forming method thereof will be described below.

In a chamber of a vacuum device, titanium (Ti) and platinum (Pt) were set in crucibles respectively as an evaporation material, the base material 22 of the watchband 21 was set as a subject to be treated to a holder and then was disposed at a distance of about 300 mm from the crucibles in which the evaporation materials were set. Thereafter, the chamber was evacuated to be 5.0 x 10⁻³ Pa.

Afterward, an argon gas and a methane gas were introduced into the vacuum chamber at a flow rate of 120 cc/min and 100 cc/min respectively and thereby the degree of vacuum was regulated to be 0.2 Pa.

Thereafter, 30 V of a cathode voltage was applied on the subject to be treated, and titanium as the evaporation material set in the crucible was evaporated with electron beam irradiation, and ion plating was carried out for about 40 min.

Then, the introduction of a nitrogen gas and a methane gas was stopped and an argon gas was introduced into the vacuum chamber at a flow rate of 100 cc/min and thereby the degree of vacuum was regulated to 0.25 Pa.

Thereafter, 10 V of a cathode voltage was applied on the subject to be treated, and platinum as the evaporation material set in the crucible was evaporated with electron beam irradiation, and ion plating was carried out for about 10 min.

After cooling for about 20 min, the chamber pressure was returned to the atmospheric pressure, and then the base material 22 of the watchband 21 was taken out as a subject to be treated. It was confirmed that the hard primary plating coating film 24 and the uniform white primary plating coating film 25 were formed on the upper surface of the base material 22 of the watchband 21.

On one part of the surface of the watchband 21, where the gold alloy coating film 27 is unnecessary for finished design, an epoxy type masking material was applied and baking of the masking material was carried out by an oven at 200° C for 60 min.

The watchband 21 to which the masking material was applied was taken out from the oven and cleaning treatment with water washing for the watchcase was carried out as a pretreatment. Thereafter, in a chamber of a vacuum device, titanium (Ti) and a gold alloy (alloy of Au, Cu and Pd) as an evaporation material and the watchband 21 as a subject to be treated were installed on a holder and disposed at a distance of about 300 mm between the gold alloy target and the watchband. Thereafter, the chamber was evacuated to be 5.0 x 10⁻³ Pa.

Afterward, an argon gas, a nitrogen gas and a methane gas were introduced into the vacuum chamber at a flow rate of 150 cc/min, 100 cc/min and 50 cc/min respectively and thereby the degree of vacuum was regulated to be 0.1 Pa.

Thereafter, 30 V of a cathode voltage was applied on the subject to be treated, and then the titanium set in the crucible as an evaporation material was evaporated with irradiation of electron beam, and ion plating was carried out for about 30 min.

Thereafter, the introduction of a nitrogen gas and a methane gas was stopped, and an argon gas was introduced into the vacuum chamber at a flow rate of 100 cc/min and thereby the degree of vacuum was regulated to be 0.25 Pa.

Thereafter, 10 V of a cathode voltage was applied on the subject to be treated, and then the gold alloy set in the crucible as an evaporation material was evaporated with irradiation of electron beam, and ion plating was carried out for about 10 min.

Since electron beam irradiation on the gold alloy as an evaporation material was started while electron beam irradiation on the titanium as an evaporation material was stopped gradually, the mixed layer 28 containing the components both of the evaporation materials was formed.

After cooling for about 20 min, the chamber pressure was returned to atmospheric pressure, and then the base material 22 of the watchband 21 was taken out as the subject to be treated. It was confirmed that the uniform pinkish gold colored gold alloy coating film 27 was formed on the base material 22 of the watchband 21.

Since on one part of the surface of the watchband 21 taken out from the chamber, the epoxy type masking material was applied, the masking material was removed by acid treatment.

By the acid treatment, the primary plating coating film 26 and the gold alloy coating film 27 formed on the upper surface of the masking material were removed together. Therefore, on the part where the masking material was applied, a part where the white primary plating coating film 25 was exposed was formed.

As described above, according to the present example, it is possible to prepare a watchband having the gold alloy coating film, which has excellent decorate properties and is of a vivid pinkish gold color, in one part of the surface, and also having the white primary plating coating film which has a feeling of high grade and excellent decorative properties.

The vacuum device used in the example is equipped with a mechanism for rotating the holder such that the subject to be treated is rotated with the rotation of the holder.

The composition of the gold alloy target has been previously regulated to the composition of the gold alloy coating film 27 by the treating conditions of the example.

As described above, on one part of the surface of the watchband 21, the uniform vivid pinkish gold colored gold alloy coating film 27 and the white primary plating coating film 25 having a feeling of high grade and excellent decorative properties can be formed according to the present example.

Moreover, since the hard primary plating coating film 26 was provided, the gold alloy coating film 27 formed on one part of the surface of the watchband 21 is improved in functional qualities such as abrasion resistance, scratch resistance, etc. Therefore, even if the coating film is flawed partly, flaws are not discerned by the titanium carbon nitride (TiCN) coating film, which is the colored primary plating coating film 26 having the color tone similar to one of the gold alloy coating film 27.

Furthermore, since the hard primary plating coating film 24 is provided, the primary plating coating film 25 formed on the overall surface of the watchband 21 was improved in functional qualities such as abrasion resistance, scratch resistance, etc. Therefore, even if the coating film is flawed partly, flaws are not discerned by the titanium carbide (TiC) coating film, which is the white primary plating coating film 24 having the color tone similar to one of the primary plating coating film 25.

Moreover, by the treatment, it is possible to prepare a two-tone design that the pinkish gold colored gold alloy coating film 27 was formed on one part of the surface, and the white primary plating coating film 25 was formed on the other part of the surface.

Furthermore, since the surface hardened layer 23 is formed on the surface of the base material 22 of the watchband 21, the functional qualities such as abrasion resistance, scratch resistance, etc are further improved by the synergistic effect with the hard coating film formed on the surface.

### POSSIBILITY OF INDUSTRIAL USE

In the examples, pinkish gold colored oxide coating films were described, however, the present invention should not be limited by these examples. It is further possible to regulate a fine color tone by adding a color tone-regulating component such as chromium (Cr), iron (Fe), cobalt (Co), nickel (Ni) and indium (In) to an evaporation material.

Furthermore, in the examples, the formation of one layer of the gold alloy coating film was described, but the present invention should not be limited by the formation. It is further possible to make layers with a more varied design by forming a gold alloy coating film having a plurality of coating films.

Moreover, in the examples, the formation of the hard primary plating coating film using titanium carbon nitride (TiCN) and titanium carbide (TiC) was described, but the present invention should not be limited by the formation. It is also possible to form a hard primary plating coating film using other substances such as a hafnium (Hf) compound, a zirconium (Zr) compound and the like.

## Claims

1. A gold alloy coating film formed by a dry plating method, which coating film comprises gold (Au) of 70 to 85 % by weight, copper (Cu) of 15 to 28 % by weight and palladium (Pd) of 0.5 to 2.0 % by weight based on 100 % by weight of the total of all the components of the gold alloy coating film.

2. The gold alloy coating film according to claim 1, which further comprises, as a color tone regulating component, at least one metal of chromium (Cr), iron (Fe), cobalt (Co), nickel (Ni) and indium (In) in an amount of more than 0 % by weight and less than 1 % by weight based on 100 % by weight of the total of all the components of the gold alloy coating film.

3. The gold alloy coating film according to claim 1 or 2, which has a chromaticity such that the color evaluation, as determined by a L*a*b* color specification system (CIE color specification system) is 75 < L*< 100, 0 < a* < 20, and 5 < b* < 25, and which is of a reddish gold color or a pinkish gold color.

4. The gold alloy coating film according to any one of claims 1 to 3, which has a thickness of 0.05 to 3.0 µm.

5. A gold alloy coating film-clad laminate comprising at least one primary plating coating film and, superimposed on the upper surface thereof, the gold alloy coating film as claimed in any one of claims 1 to 4, wherein the primary plating coating film comprises at least one selected from at least one metal of a Group 4a, a Group 5a, a Group 6a, nickel (Ni) and chromium (Cr) in the Periodic Table, a carbide of the metal, a nitride of the metal, a carbon nitride of the metal and an alloy of the metals.

6. A gold alloy coating film-clad laminate comprising at least one primary plating coating film and, superimposed on the upper surface thereof, the gold alloy coating film as claimed in any one of claims 1 to 4, wherein the primary plating coating film comprises at least one selected from at least one metal of titanium (Ti), zirconium (Zr), hafnium (Hf), tantalum (Ta), vanadium (V), nickel (Ni) and chromium (Cr), a carbide of the metal, a nitride of the metal, a carbon nitride of the metal and an alloy of the metals, and the primary plating coating film is hard.

7. A gold alloy coating film-clad laminate comprising at least one primary plating coating film and, superimposed on the upper surface thereof, the gold alloy coating film as claimed in any one of claims 1 to 4, wherein the primary plating coating film comprises a hard titanium alloy which comprises titanium (Ti) of 60 to 88 % by weight, carbon (C) of 2 to 15 % by weight and nitrogen (N) of 10 to 25 % by weight based on 100 % by weight of the total of all the components of the primary plating coating film.

8. The gold alloy coating film-clad laminate according to any one of claims 5 to 7, wherein a mixed layer is present between the gold alloy coating film and the primary plating coating film and comprises a mixture of components which form the gold alloy coating film and components which form the primary plating coating film.

9. A gold alloy coating film-clad article comprising a base material and, superimposed on at least one part of the upper surface thereof, the gold alloy coating film as claimed in any one of claims 1 to 4.

10. A gold alloy coating film-clad article, which comprises the gold alloy coating film-clad laminate as claimed in any one of claims 5 to 8, and which further comprises a base material formed on the lowermost surface of the primary plating coating film, and the gold alloy coating film formed on at least one part of the uppermost surface of the primary plating coating film.

11. The gold alloy coating film-clad article according to claim 10, which further comprises a base material exposed part where the primary plating coating film lacks.

12. The gold alloy coating film-clad article according to any one of claims 9 to 11, which further comprises at least one protective film formed on the surface of the gold alloy coating film.

13. The gold alloy coating film-clad article according to any one of claims 9 to 12, wherein the base material comprises at least one metal selected from platinum (Pt), gold (Au), silver (Ag), copper (Cu), titanium (Ti), aluminum (Al), tungsten (W), tantalum (Ta), zirconium (Zr), silicon (Si), stainless steel and brass, or an alloy of these metals.

14. The gold alloy coating film-clad article according to any one of claims 9 to 12, wherein the base material comprises sintered ceramic, glass or plastic.

15. The gold alloy coating film-clad article according to any one of claims 9 to 12, wherein the base material is a metal subjected to hardening treatment, and the hardening treatment is any one of
a) at least one chemical reaction of nitriding, carbonization and oxidation,
b) doping with at least one element selected from nitrogen, carbon and oxygen, and
c) solid solution with at least one element selected from nitrogen, carbon and oxygen.

16. The gold alloy coating film-clad article according to any one of claims 9 to 15, wherein the base material is an ornament.

17. The gold alloy coating film-clad article according to any one of claims 9 to 15, wherein the base material is an exterior part for a watch.

## Amended claims

### Amended claims under Art. 19.1 PCT

**1.** (Amended) A gold alloy coating film formed by a dry plating method, which coating film comprises gold (Au) of 70 to 85 % by weight, copper (Cu) of 15 to 28 % by weight and palladium (Pd) of 0.5 to 2.0 % by weight based on 100 % by weight of the total of all the components of the gold alloy coating film, and which coating film has a thickness of 0.5 to 3.0 µm.

**2.** The gold alloy coating film according to claim 1, which further comprises, as a color tone regulating component, at least one metal of chromium (Cr), iron (Fe), cobalt (Co), nickel (Ni) and indium (In) in an amount of more than 0 % by weight and less than 1 % by weight based on 100 % by weight of the total components of the gold alloy coating film.

**3.** The gold alloy coating film according to claim 1 or 2, which has a chromaticity such that the color evaluation, as determined by a L*a*b* color specification system (CIE color specification system) is 75 < L*< 100, 0 < a* < 20, and 5 < b* < 25, and which is of a reddish gold color or a pinkish gold color.

**4.** (Amended) A gold alloy coating film-clad laminate comprising at least one primary plating coating film and, superimposed on the upper surface thereof, the gold alloy coating film as claimed in any one of claims 1 to 3, wherein the primary plating coating film comprises at least one selected from at least one metal of a Group 4a, a Group 5a, a Group 6a, nickel (Ni) and chromium (Cr) in the Periodic Table, a carbide of the metal, a nitride of the metal, a carbon nitride of the metal and an alloy of the metals.

**5.** (Amended) A gold alloy coating film-clad laminate comprising at least one primary plating coating film and, superimposed on the upper surface thereof, the gold alloy coating film as claimed in any one of claims 1 to 3, wherein the primary plating coating film comprises at least one selected from at least one metal of titanium (Ti), zirconium (Zr), hafnium (Hf), tantalum (Ta), vanadium (V), nickel (Ni) and chromium (Cr), a carbide of the metal, a nitride of the metal, a carbon nitride of the metal and an alloy of the metals, and the primary plating coating film is hard.

**6.** (Amended) A gold alloy coating film-clad laminate comprising at least one primary plating coating film and, superimposed on the upper surface thereof, the gold alloy coating film as claimed in any one of claims 1 to 3, wherein the primary plating coating film comprises a hard titanium alloy which comprises titanium (Ti) of 60 to 88 % by weight, carbon (C) of 2 to 15 % by weight and nitrogen (N) of 10 to 25 % by weight based on 100 % by weight of the total of all the components of the primary plating coating film.

**7.** (Amended) The gold alloy coating film-clad laminate according to any one of claims 4 to 6, wherein a mixed layer is present between the gold alloy coating film and the primary plating coating film and comprises a mixture of components which form the gold alloy coating film and components which form the primary plating coating film.

**8.** (Amended) A gold alloy coating film-clad article comprising a base material and, superimposed on at least one part of the upper surface thereof, the gold alloy coating film as claimed in any one of claims 1 to 3.

**9.** (Amended) A gold alloy coating film-clad article, which comprises the gold alloy coating film-clad laminate as claimed in any one of claims 4 to 7, and which further comprises a base material formed on the lowermost surface of the primary plating coating film, and the gold alloy coating film formed on at least one part of the uppermost surface of the primary plating coating film.

**10.** (Amended) The gold alloy coating film-clad article according to claim 9, which further comprises a base material exposed part where the primary plating coating film lacks.

**11.** (Amended) The gold alloy coating film-clad article according to any one of claims 8 to 10, which further comprises at least one protective film formed on the surface of the gold alloy coating film.

**12.** (Amended) The gold alloy coating film-clad article according to any one of claims 8 to 11, wherein the base material comprises at least one metal selected from platinum (Pt), gold (Au), silver (Ag), copper (Cu), titanium (Ti), aluminum (Al), tungsten (W), tantalum (Ta), zirconium (Zr), silicon (Si), stainless steel and brass, or an alloy of these metals.

**13.** (Amended) The gold alloy coating film-clad article according to any one of claims 8 to 11, wherein the base material comprises sintered ceramic, glass or plastic.

**14.** (Amended) The gold alloy coating film-clad article according to any one of claims 8 to 11, wherein the base material is a metal subjected to hardening treatment, and the hardening treatment is any one of
a) at least one chemical reaction of nitriding, carbonization and oxidation,
b) doping with at least one element selected from nitrogen, carbon and oxygen, and
c) solid solution with at least one element selected from nitrogen, carbon and oxygen.

**15.** (Amended) The gold alloy coating film-clad article according to any one of claims 8 to 14, wherein the base material is an ornament.

**16.** (Amended) The gold alloy coating film-clad article according to any one of claims 8 to 14, wherein the base material is an exterior part for a watch.

**17.** (Cancelled)
